# EUROPEAN PATENT SPECIFICATION

(11) **EP 1 890 339 B1**
(45) Date of publication and mention of the grant of the patent: **28.04.2010**
(21) Application number: 07016285.4
(22) Date of filing: 20.08.2007
(51) Int. Cl.: H01L 31/18, B32B 37/10

(54) **Laminating apparatus**
Laminiervorrichtung
Appareil de laminage

(30) Priority: 18.08.2006 JP 2006223307
(43) Date of publication of application: 20.02.2008
(73) Proprietor: NPC Incorporated, Arakawa-ku, Toyko 116-0003 (JP)
(72) Inventor: Chikaki, Yoshiro, Arakara-ku Tokyo 116-0003 (JP)
(74) Representative: Samson & Partner

(56) References cited:
- EP-A- 0 755 080
- EP-A- 1 059 675
- EP-A- 1 550 548
- DE-A1- 10 048 974
- JP-A- 10 214 987
- JP-A- 11 204 811
- US-A- 4 382 833
- US-A- 5 968 392
- US-A1- 2004 171 187
- US-A1- 2005 056 363

## Description

### Background of the Invention

### 1. Field of the Invention

The present invention relates to a laminating apparatus particularly suitable for producing a laminated object in a thin plate shape such as a solar battery module.

### 2. Description of the Related Art

In recent years, various developments have been made with respect to solar batteries. The solar batteries have various forms, and a crystal type using single crystal silicon and polycrystalline silicon, an amorphous type using amorphous silicon (noncrystal silicon) and the like are contrived. However, each type of solar battery easily causes a chemical change and has the property susceptible to a physical impact. Therefore, solar battery modules formed by laminating solar batteries with transparent vinyl films, reinforced glass, heat-resistant glass and the like are generally used. Lamination of a solar battery module is performed by inserting a string (solar battery cell) between a vinyl film or glass and a back sheet via a filler such as, for example, an EVA (ethylene vinyl acetate) resin, and melting the filler inside the object to be laminated by heating it under vacuum.

Conventionally, as a laminating apparatus for producing such solar battery modules and the like, a laminating apparatus having an upper chamber including a diaphragm expandable downward and a lower chamber including a heater panel is publicly known. Such a laminating apparatus has a constitution in which after the upper chamber and the lower chamber are hermetically sealed and decompressed to be under vacuum (low pressure), atmosphere is introduced into the diaphragm, and thereby, the solar battery module is sandwiched and pressed between the diaphragm and the heater panel, and heated by the heater panel. In a laminating apparatus described in Japanese Patent Application Laid-open No. Hei 10-214987, a plurality of heaters are provided in a heater panel to uniformly heat a solar battery module.

Document US 2004/171187 A1 discloses the features of the preamble of claim 1. It shows a laminating apparatus with an upper chamber provided with a diaphragm freely expanding downward and with a lower chamber provided with a heater board. The upper chamber and the lower chamber can be freely opened or closed. The apparatus is configured to de-pressurize the upper chamber and the lower chamber while providing a body to be laminated onto the heater board provided in the lower chamber, to heat the body, and to introduce an atmospheric air into the upper chamber, to thereby laminate the body by pressing it between a top surface of the heater board and the diaphragm. The heater board is heated by electrifying the heater after contact-bonding the body with the diaphragm. ,

Documents DE 100 48 974 A1, US 2005/056363 A1, EP-A-1 059 675, EP-A-0 755 080, and JP 10 214987 A disclose laminators with an upper chamber provided with a diaphragm, and a lower chamber provided with a heater board that can be electrically heated.

### Summary of the Invention

However, in a laminating apparatus, ceramic heaters, sheathed heaters or the like are generally provided in a space formed in a heater panel, and a gap exists between the both (the heater panel, the heaters). Therefore, when an internal pressure of a lower chamber is changed, for example, from atmospheric pressure to vacuum, from vacuum back to atmospheric pressure, or the like after the heaters are temperature-adjusted to heat the heaters to a predetermined temperature, the density of gas existing in the gap between the heater panel and the heaters increases/decreases, resulting in a change in thermal conductivity between the both (the heater panel, the heaters). Consequently, for example, if the heaters are temperature-adjusted under vacuum to heat the heater panel to a predetermined temperature and in this state the internal pressure is changed to atmospheric pressure, heat of the heaters is rapidly transferred to the heater panel, and as a result, the temperature of the heater panel deviates from the set predetermined temperature. Thus, the temperature control of the heater panel is difficult when the laminating apparatus described in the aforesaid Japanese Patent Application Laid-open No. Hei 10-214987 is used.

Further, in the laminating apparatus described in the aforesaid Japanese Patent Application Laid-open No. Hei 10-214987, since the heater panel needs to be set to the predetermined temperature again after the internal pressure of the lower chamber is changed, a laminating process requires the extra time and work, resulting in lowered production efficiency. In particular, due to recent complication and diversification of the laminating procedure, frequent changes of the internal pressure of the lower chamber in the course of the laminating process take place in many cases, and if the aforesaid extra time and work are required each time, production efficiency is lowered.

The present invention was made in view of the above problems, and an object thereof is to provide a laminating apparatus realizing easier temperature control of its heater panel and having higher production efficiency of laminated objects such as solar battery modules and the like than has been conventionally realized.

To solve the above problems, a laminating apparatus of the present invention is a laminating apparatus heating an object to be laminated and pressing the object to be laminated in a sandwiched state according to claim 1, wherein the apparatus includes : a first space whose internal pressure is adjustable; a second space which is separated from the first space by an expandable diaphragm and whose internal pressure is adjustable; a heater panel provided inside the second space; one hole or more provided inside the heater panel; and one heater or more inserted in the hole, a heat transfer material filled inside the hole, wherein the hole is hermetically sealed.

In the above laminating apparatus, a total length of the one heater or more may be set shorter than a length of the hole. In the above laminating apparatus, the object to be laminated may be a solar battery module. In the above laminating apparatus, the hole may include a hole penetrating through the heater panel. In the above laminating apparatus, the heaters may be inserted from both ends of the long hole penetrating through the heater panel, with a space formed between tips of the inserted heaters. In the above laminating apparatus, the hole may include a hole having one longitudinal end open and the other end closed. The above laminating apparatus may further include auxiliary heaters provided on an undersurface of the heater panel, at positions of longitudinal end portions of the one hole or more.

### Brief Description of the Drawings

FIG 1 is a plane view of a laminating apparatus according to an embodiment of the present invention;
FIG. 2 is a side view of the laminating apparatus according to the embodiment of the present invention;
FIG 3 is a sectional view taken along the arrows A-A in FIG. 1;
FIG 4 is an explanatory view showing an operation of a laminating part;
FIG 5 is a plane view of a heater panel;
FIG. 6 is a side view of the heater panel;
FIG. 7 is an enlarged sectional view of a long hole shown in FIG 5, taken along a horizontal plane including its axis;
FIG. 8 is a sectional view schematically showing the structure of a left heater out of two heaters shown in FIG 7;
FIG 9 is a plane view of a solar battery module;
FIG. 10 is an enlarged sectional view of the solar battery module;
FIG. 11 is a view showing part of the structure of a laminating apparatus according to a second embodiment of the present invention;
FIG 12 is a view showing part of the structure of a laminating apparatus according to a third embodiment of the present invention; and
FIG 13 is a structural view showing part of the structure of a laminating apparatus according to a fourth embodiment of the present invention.

### Detailed Description of the Invention

Hereinafter, preferred embodiments of the present invention will be described based on a laminating apparatus 1 favorable for performing laminate treatment for a solar module M as an example of an object to be laminated. In this specification and the drawings, the components practically having the same functions and constitutions are given the same reference numerals and characters, and the redundant explanation of them will be omitted.

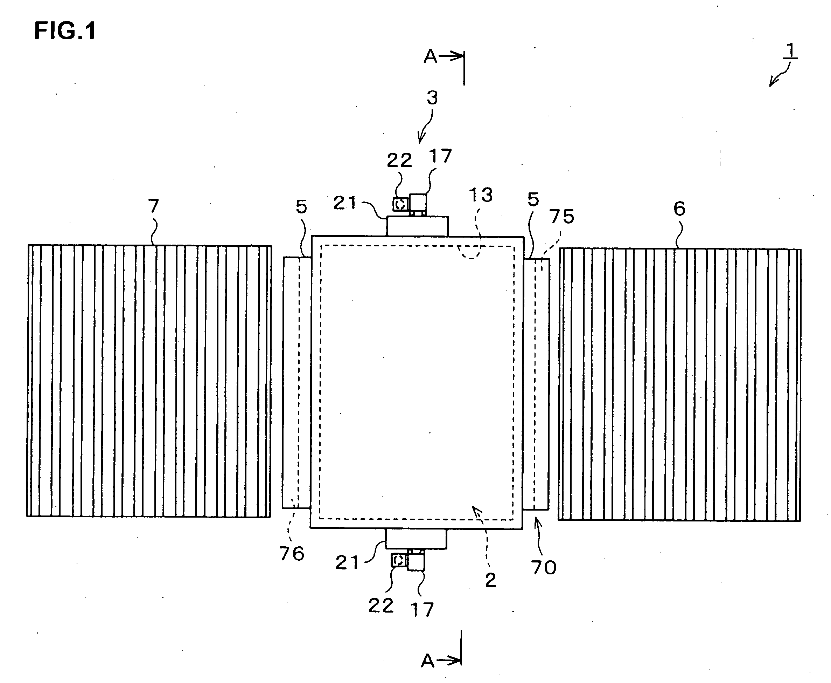

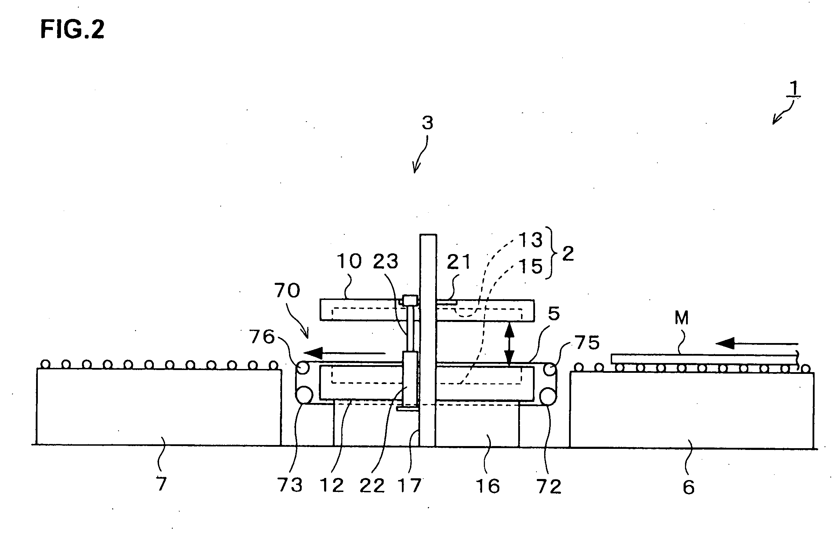

FIG 1 is a plane view of the laminating apparatus 1 according to the embodiment of the present invention. FIG 2 is a side view of the laminating apparatus 1 according to the embodiment of the present invention. As shown in FIGS. 1 and 2, the laminating apparatus 1 includes a laminate unit 3 including a laminating part 2 inside. The laminating part 2 is formed in such a size to be able to laminate an object to be laminated in a size about 2150 mm wide in the lateral direction and about 4000 mm wide in the direction toward the rear surface from the front surface at the maximum, for example.

The laminating apparatus 1 includes a conveying sheet 5 which enters the laminate unit 3 with the solar battery module M carried thereon. A supply conveyor 6 which conveys the solar battery module M to be subjected to the laminate treatment toward the laminate unit 3 is disposed on the right of the laminate unit 3. An unloading conveyor 7 which conveys the solar battery module M from the laminate unit 3 side is disposed on the left of the laminate unit 3. The solar battery module M is conveyed leftward in FIGS. 1 and 2 as it is transferred to the supply conveyor 6, the conveying sheet 5 and the unloading conveyor 7 in sequence.

As shown in FIG. 2, the laminate unit 3 includes an upper case 10 and a lower case 12. An upper chamber 13 is formed in a lower side of an inside of the upper case 10, and a lower chamber 15 is formed in an upper side of an inside of the lower case 12. The laminating part 2 is constituted of the upper chamber 13 and the lower chamber 15.

The lower case 12 is fixedly supported on an upper side of a base 16. Brackets 21 movable along support pillars 17 vertically provided on a front face side and a back face side (a front side and a rear side in FIG 2) of the base 16 are included, and the front face side and the back face side of the upper case 10 are respectively fixed to the brackets 21. Thereby, the upper case 10 rises and lowers along the support pillars 17, and is constituted to be risible and lowerable above the lower case 12 while keeping a posture parallel with the lower case 12.

A hydraulic cylinder 22 is fitted to a side of the support pillar 17, and a tip end of a piston rod 23 of the cylinder 22 is connected to an undersurface of the bracket 21 fixed to the upper case 10. Accordingly, when the piston rod 23 extends by operation of the cylinder 22, the upper case 10 rises to separate from the top surface of the lower case 12, and thereby, the laminating part 2 constituted of the upper chamber 13 and the lower chamber 15 is in an open state. On the other hand, when the piston rod 23 contracts by operation of the cylinder 22, the upper case 10 lowers to be in close contact with the top surface of the lower case 12, and the laminating part 2 is in a hermetically sealed state.

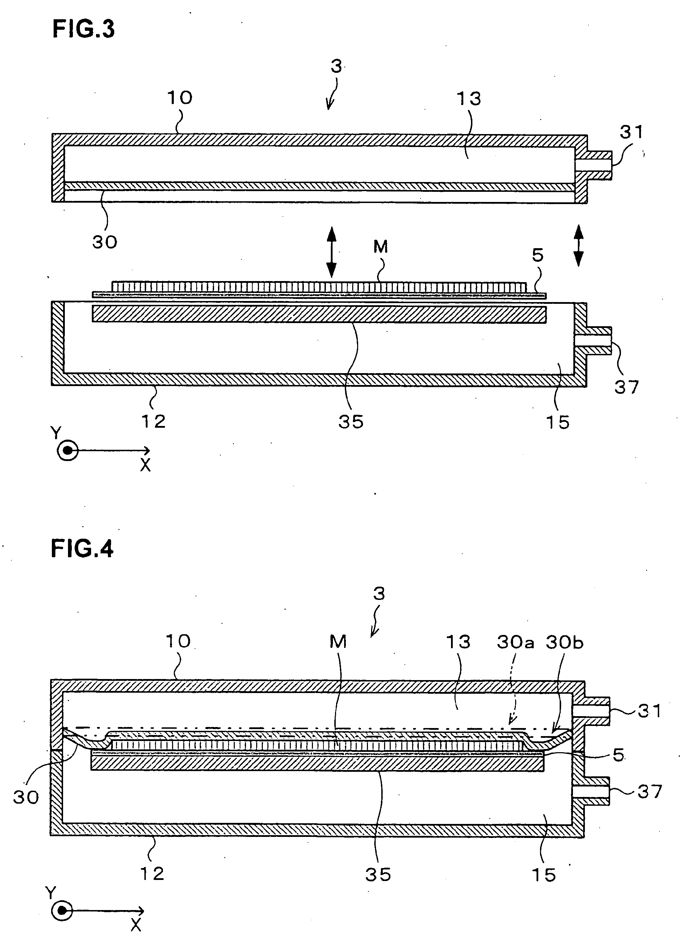

FIG 3 is a sectional view taken along the arrows A-A in FIG. 1. An arrow direction X shown in FIG. 3 shows a longitudinal direction of the heater panel 35 (that is, a longitudinal direction of heaters 41 which will be described later), and an arrow direction Y shows a width direction of the heater panel 35 (namely, the loading and unloading direction of the solar battery module M). As shown in FIG 3, a diaphragm 30 is fitted in such a way as to partition the inside of the upper case 10 horizontally, and a first space enclosed by the diaphragm 30 and an inner wall surface of the upper case 10 constitutes the upper chamber 13. As the diaphragm 30, for example, a silicon diaphragm, a butyl diaphragm or the like is used. An inlet/outlet port 31 is provided in a side surface of the upper case 10 to communicate with the upper chamber 13, so that the inside of the upper chamber 13 can be evacuated through the inlet/outlet port 31, and atmospheric pressure can be introduced into the upper chamber 13 through the inlet/outlet port 31.

The heater panel 35 is disposed inside a second space enclosed by the diaphragm 30 and an inner wall surface of the lower case 12. The heater panel 35 has a constitution in which the heaters 41 are provided inside a metal plate 36 made of aluminum, for example, as will be described later. The solar battery module M carried to a position above the heater panel 35 by the conveying sheet 5 is constituted to be able to be lifted from the conveying sheet 5 and placed on the conveying sheet 5 by being raised and lowered by a raising and lowering mechanism (not shown) using pins. Incidentally, though the case where the solar battery module M is raised and lowered without the heaters 41 being moved is described in this embodiment, the heaters 41 may be raised and lowered.

An inlet/outlet port 37 is provided in a side surface of the lower case 12 to communicate with the lower chamber 15, so that the inside of the lower chamber 15 can be evacuated through the inlet/outlet port 37, and atmospheric pressure can be introduced into the lower chamber 15 through the inlet/outlet port 37.

FIG. 4 is a view showing the state in which the upper chamber 10 is lowered from the state shown in FIG. 3, and is brought into close contact with the top surface of the lower case 12 to seal the laminating part 2 hermetically. When an internal pressure difference is caused by using the inlet/outlet ports 31 and 37 in the hermetically sealed state shown in FIG. 4 so that the internal pressure of the upper chamber 10 becomes larger than the internal pressure of the lower chamber 15, the diaphragm 30 changes from the state shown by the two-dot chain line 30a in FIG. 4 to the state shown by the solid line 30b in FIG 4, to sandwich and press the object to be laminated M against the heater panel 35.

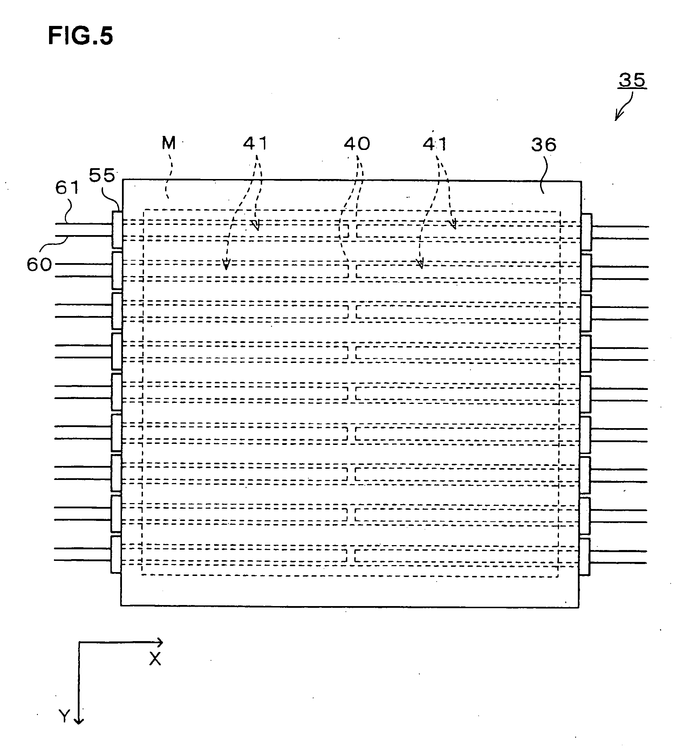

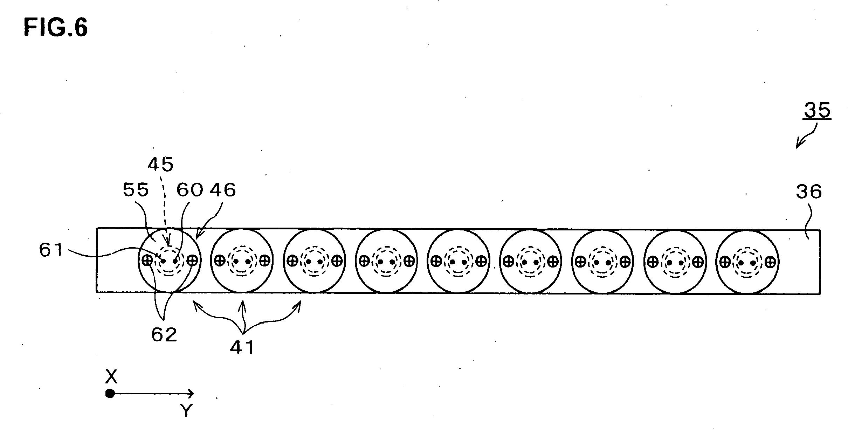

Next, a structure of the heater panel 3 5 will be described. FIG. 5 is a plane view of the heater panel 35. FIG. 6 is a side view of the heater panel 35.

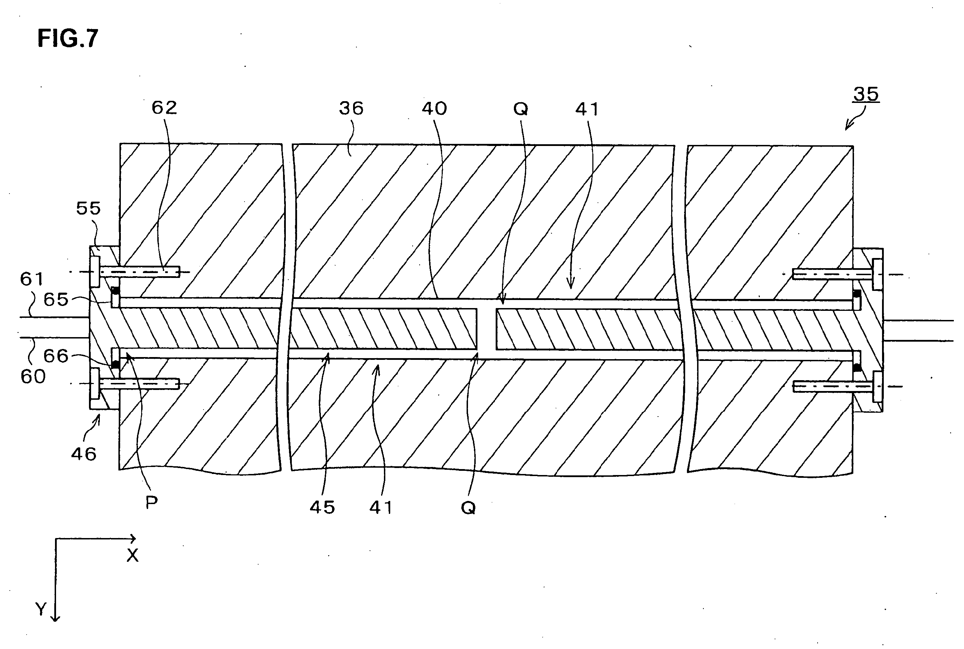

As shown in FIG 5 and FIG 6, nine long holes 40 extending along the longitudinal direction X of the heater panel 35 are provided in the metal plate 36 of the heater panel 35. The holes 40 are arranged in parallel to one another. Further, these nine holes 40 are arranged at equal spaced intervals along the width direction Y of the heater panel 35. Each of the holes 40 has a perfect circular cross section and horizontally penetrates through the inside of the heater panel 35. In each of the nine holes 40, the two rod heaters 41 are inserted from both sides thereof to extend along the longitudinal direction X. FIG 7 is an enlarged sectional view of the hole 40 and the heaters 41 shown in FIG 5, taken along a horizontal plane including the axis of the hole 40.

As shown in FIG 7, the two rod heaters 41 inserted in each of the holes 40 are arranged, with a longitudinal direction thereof set along the longitudinal direction X of the hole 40, and are supported by both end sides of the hole 40 respectively. In this embodiment, all the two heaters 41 inserted in each of the nine holes 40, that is, the totally 18 heaters 41 are equal in length in the longitudinal direction X. Further, the sum of the lengths in the longitudinal direction X of the two heaters 41 in each of the holes 40 is set shorter than the length of the hole 40 in the longitudinal direction X. Specifically, as shown in FIGS. 5 and 7, at a center position in the longitudinal direction X of the heater panel 35, tip portions of the two heaters 41 are apart from each other by a predetermined distance. This predetermined distance is preferably set to as small a value as possible among values with which the heaters 41 do not collide with each other or the heaters 41 do not collide with an inner surface of the long hole 40 when the heaters 41 expand, in consideration of the length by which the heaters 41 expands in the longitudinal direction X when heated.

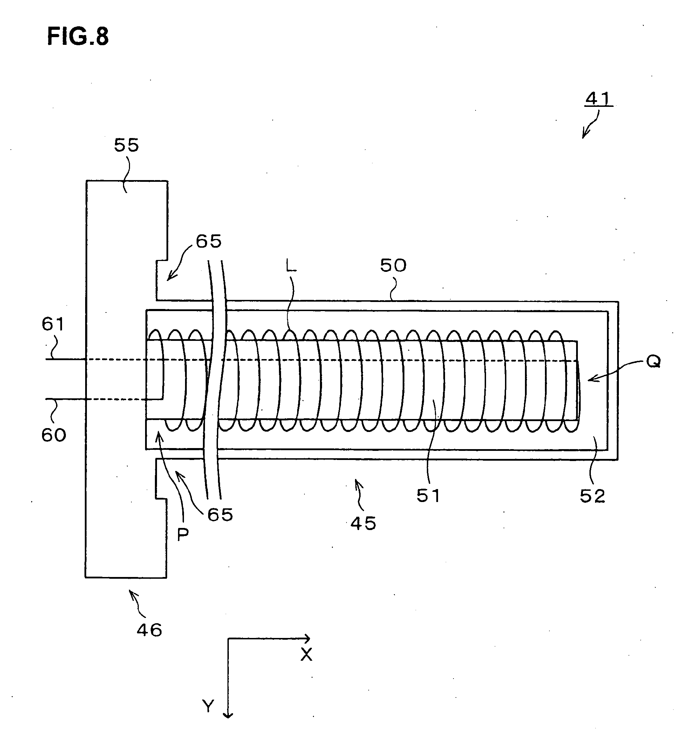

In this embodiment, cartridge heaters are used as the heaters 41. As shown in FIG. 7, the heater 41 is composed of a cylindrical heating portion 45 and a flange portion 46 provided at one end of the heating portion 45 and having a diameter larger than a diameter of the heating portion 45. FIG. 8 is a sectional view schematically showing the structure of the left heater 41 out of the two heaters 41 shown in FIG. 7. As shown in FIG 8, the heating portion 45 of the heater 41 is composed of a hollow metal tube 50 and a columnar core 51 concentrically disposed inside the metal tube 50 and made of, for example, sintered magnesia or the like. As the metal tube 50, for example, iron, brass, copper, stainless steel, Inconel or the like may be used. One end of the metal tube 50 is closed, and the other end is connected to a metal disk 55 of the flange portion 46 to be hermetically closed. Insulating powder 52 with high thermal conductivity is filled between the metal tube 50 and the core 51.

Around an outer peripheral surface of the core 51, one continuous lead wire L is spirally wound. The lead wire L is wound up to a tip portion Q of the core 51 from a root portion P, of the core 51, coupled to the metal disk 55 of the flange portion 46. One end 60 of the lead wire L passes from the root portion P of the core 51 through the metal disk 55 of the flange portion 46 to be led to the outside of the heater 41. The other end 61 of the lead wire L passes from the tip portion Q of the core 51 to pass through the metal disk 55 via the inside of the core 51 to be led to the outside of the heater 41. Passing a current from the both ends 60, 61 of the lead wire L which are lea out can cause the heating by the heater 41.

As shown in FIGS. 6 and 7, the flange portions 46 of the heaters 41 are fixed to the metal plate 36 of the heater panel 35 by fixtures 62 such as screws, for example. In this embodiment, screws each composed of a shaft portion including a thread and a head portion are used as the fixtures 62. In each of the flange portions 46, the two fixtures 62 are provided at the same height position as the axis of the hole 40 so as to be laterally symmetrical with respect to the hole 40. The fixtures 62 penetrate through the flange portions 46 of the heaters 41 in the longitudinal direction X to screw-connect the flange portions 46 and the metal plate 36. Consequently, the heaters 41 inserted in the holes 40 are fixed. In its portion coupled to the metal tube 50, each of the flange portions 46 has an annular groove 65 concentrically adjacent to an outer periphery of the metal tube 50. As shown in FIG. 7, an annular O-ring 66 is fitted in each of the annular grooves 65. Therefore, in the state in which the metal disks 55 of the flange portions 46 are pressed against and fixed to the metal plate 36 of the heater panel 35 by the fixtures 62, the O-rings 66 are compressed to be in close contact with both the metal disks 55 and the metal plate 36, thereby hermetically sealing the inside of the holes 40, which prevents gas from flowing into and out of the holes 40.

In this embodiment, in the hermetically sealed hole 40, predetermined gas with high thermal conductivity such as air, for example, is filled in advance. Instead of filling gas, a certain heat-transfer material such as liquid is filled in the hole 40.

Next, a conveying system of the laminating apparatus 1 will be described. As shown in FIGS. 1 and 2, the conveying sheet 5 formed into an endless shape is constituted to circulate and pass above and below the lower case 12 of the laminate unit 3 by the operation of a conveying sheet moving mechanism 70. The conveying sheet 5 is formed into a long band shape. In the conveying sheet 5, only a part on which the solar battery module M is placed in the conveying direction may be formed in the band shape.

As shown in FIG. 2, the conveying sheet moving mechanism 70 includes rotary rolls 72 and 73 which circulatingly drive the conveying sheet 5, and guide rolls 75 and 76 which guide the conveying sheet 5. The rotary roll 72 is disposed at a lower side on the right of the lower case 12 of the laminate unit 3, whereas the rotary roll 73 is disposed at a lower side on the left of the lower case 12. Above the rotary roll 72, the guide roll 75 is rotatably disposed along the height of the upper edge of the right side of the lower case 12, whereas above the rotary roll 73, the guide roll 76 is rotataby disposed along the height of the upper edge of the left side of the lower case 12.

By rotationally driving the rotary rolls 72 and 73 in the counterclockwise direction in FIG. 2, the conveying sheet 5 can be let out from the rotary rolls 72 and 73 and circulated in the counterclockwise direction (FIG 2). In this case, the conveying sheet 5 let out from the rotary roll 72 changes the direction to the horizontal direction along the circumferential surface of the guide roll 75, thereafter, passes above the lower case 12 of the laminate unit 3 in the leftward direction in FIG 2, changes the direction to the downward direction along the circumferential surface of the guide roll 76, and advances to the rotary roll 73. As shown in FIG 2, by disposing the guide rolls 75 and 76 at the same height on the right and left of the laminate unit 3, the conveying sheet 5 can be supplied above the lower case 12 of the laminate unit 3 in the horizontal posture. The top surface of the conveying sheet 5 above the lower case 12 of the laminate unit 3, the top surface of the supply conveyor 6 and the top surface of the unloading conveyor 7 are disposed at heights which are substantially the same as one another.

On the other hand, by rotationally driving the rotary rolls 72 and 73 in the clockwise direction in FIG 2, the conveying sheet 5 is let out from the rotary rolls 72 and 73 and can be circulated in the clockwise direction (FIG 2). By rotating both the rotary rolls 72 and 73 in one direction like this, the conveying sheet 5 can be moved in a desired direction with the surface being substantially horizontal, and can be passed between the upper case 10 and the lower case 12 of the laminate unit 3.

The surface of the conveying sheet 5 is preferably formed of a material excellent in removability to which the filler does not easily attach or from which the attached filler can be easily removed, in order to avoid attachment of the filler which is squeezed out of the solar battery module M when sandwiched and pressed by the diaphragm 30 in the laminating part 2. For example, a heat-resistant glass cloth sheet or the like coated with Teflon (registered trademark) (fluorocarbon resin) or the like is preferably used as the conveying sheet 5. Alternatively, the surface of the conveying sheet 5 may be coated with a material excellent in removability such as a fluorocarbon resin, for example.

In the conveying sheet moving mechanism 70, the solar battery module M to be subjected to laminate treatment is placed on the top surface of the conveying sheet 5, on the right of the laminate unit 3, and the conveying sheet 5 is intermittently moved by rotational drive of the rotary rolls 72 and 73, whereby the solar battery modules M can be moved in sequence to a position between the upper case 10 and the lower case 12 of the laminate unit 3. Specifically, by moving the conveying sheet 5, the solar battery modules M can be moved in sequence to the position between the upper chamber 13 and the lower chamber 15 of the laminating part 2. While the solar battery module M is subjected to laminate treatment while being sandwiched by the upper chamber 13 and the lower chamber 15 of the laminate unit 3, the undersurface of the solar battery module M is supported by the top surface of the conveying sheet 5, and the conveying sheet 5 is intermittently moved, whereby the laminated solar battery modules M are sequentially conveyed to the left of the laminate unit 3.

The diaphragm 30 is disposed above the solar battery module M which is conveyed into the laminating part 2 of the laminate unit 3 while placed on the conveying sheet 5, and the heater panel 35 is disposed below the solar battery module M and the conveying sheet 5. Between the upper case 10 and the lower case 12, the solar battery module M placed on the conveying sheet 5 can be raised and lowered by the raising and lowering mechanism (not shown) using the pins. Therefore, the solar battery module M can be lifted up to an upper position a predetermined distance apart from the heater panel 35, and can be lowered from the upper position back to the conveying sheet 5. In this embodiment, the case is described where the solar battery module M is raised and lowered without the heater panel 35 being moved, but the heater panel 35 may be raised and lowered.

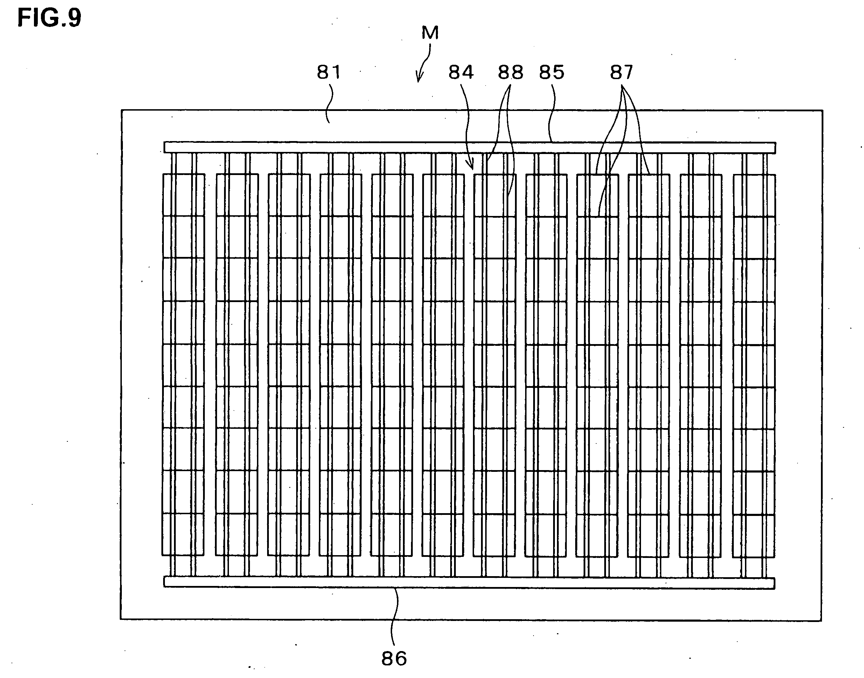

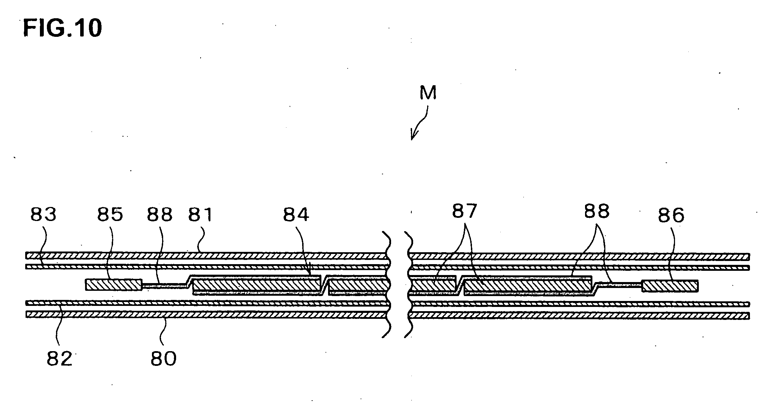

FIGS. 9 and 10 show the solar battery module M as one example of the laminated object which is favorably produced by the laminating apparatus 1 of the present invention. As shown in FIG 9, the solar battery module M is formed in a rectangular thin plate shape, with a size of, for example, about 2150 mm × about 4000 mm.

As shown in FIG 9, the solar battery module M is structured such that strings 84 are sandwiched between a transparent cover glass 80 disposed on a lower side and a protective material 81 disposed on an upper side via fillers 82 and 83. As the protective material 81, for example, a transparent material such as a PE resin is used. As the fillers 82 and 83, for example, an EVA (ethylene vinyl acetate) resin or the like is used. Each of the strings 84 includes solar battery cells 87 which are connected between electrodes 85 and 86 via lead wires 88. In each of the solar battery cells 87, a front surface (light receiving surface) is covered with the cover glass 80 on the lower side, and a back surface is covered with the protective material 81.

The solar battery module M as the laminated object constituted as above is produced by the laminating apparatus 1 according to the embodiment of the present invention according to the following procedure.

First, in FIG 1, the solar battery module M to be laminated is positioned on and supplied to the supply conveyor 6 by means such as a robot not shown. On the occasion of supply onto the supply conveyor 6 of the laminating apparatus 1, the solar battery module M is in the posture such that the protective material 81 shown in FIGS. 9 and 10 is located on the top surface side of the solar battery module M. Further, a short side direction of the solar battery module M is directed in the conveying direction (leftward direction in FIGS. 1 and 2). The solar battery module M thus placed on the supply conveyor 6 is conveyed leftward by the operation of the supply conveyor 6, and the solar battery module M is transferred to the conveying sheet 5 from the supply conveyor 6.

On the occasion of transferring the solar battery module M to the conveying sheet 5, the upper case 10 of the laminate unit 3 is lifted up, and the laminating part 2 is brought into an open state. The operation of lifting up the upper case 10 is performed by the extending operation of the cylinder 22 explained in FIG 2. Thus, the conveying sheet 5 is in the state capable of advancing and retreating between the upper case 10 and the lower case 12 of the laminate unit 3. Subsequently, by advancing the conveying sheet 5 leftward above the lower case 12 by rotational drive of the rotary rolls 72 and 73 while operating the supply conveyor 6, the solar battery module M is transferred to the conveying sheet 5 from the supply conveyor 6, and the solar battery module M supplied onto the top surface of the conveying sheet 5 is further moved leftward.

When the solar battery module M is moved to the position between the upper case 10 and the lower case 12 of the laminate unit 3, the rotational drive of the rotary rolls 72 and 73 is stopped, and movement of the conveying sheet 5 is stopped. In this way, in the laminate unit 3, the solar battery module M is caused to stand still between the upper chamber 13 of the upper case 10 and the lower chamber 15 of the lower case 12.

Next, the upper case 10 is lowered in the laminate unit 3, and the solar battery module M is brought into the state covered with the upper chamber 13, thereby bringing the laminating part 2 into the hermetically sealed state. In the laminate unit 3, the operation of lowering the upper case 10 is carried out by the contracting operation of the cylinder 22 described in FIG 2. Thus, the solar battery module M is in the state housed in the laminating part 2 of the laminate unit 3.

Hereinafter, the laminate treatment of the solar battery module M in the laminate unit 3 will be described. First, in the laminate unit 3, the inside of the upper chamber 13 and the inside of the lower chamber 15 are evacuated at the same time through the inlet/outlet ports 31 and 37. While the inside of the upper chamber 13 and the inside of the lower chamber 15 are evacuated, the heaters 41 may be heated to heat the heater panel 35 in the lower chamber 15 to a predetermined temperature in advance. If heating of the heater panel 35 is started with the inside of the lower chamber 15 decompressed while the solar battery module M on the conveying sheet 5 is raised by the operation of the raising and lowering mechanism not shown and is kept at an upper position away from the heater panel 35, the heat insulating effect is extremely high, and there is less fear of heat being transferred to the solar battery module M during decompression. After the inside of the upper chamber 13 and the inside of the lower chamber 15 are both evacuated to, for example, 0.7 to 1.0 Torr, the solar battery module M is lowered by the operation of the raising and lowering mechanism not shown inside the lower chamber 15, and is placed on the conveying sheet 5. Thereby, the solar battery module M placed on the conveying sheet 5 is in the state in which it is in thermal contact with the top surface of the heater panel 35 inside the lower chamber 15, so that the solar battery module M is heated. By the heating, in the solar battery module M, chemical reaction of the EVA resin that is the fillers 62 and 63 is promoted, and cross linking is performed.

In this state, atmospheric pressure is introduced into the upper chamber 13 through the inlet/outlet port 31, and the diaphragm 30 is expanded downward in the laminating part 2, whereby the solar battery module M is sandwiched and pressed between the top surface of the heater panel 35 and the diaphragm 30. In this way, by the heating, and sandwiching and pressing, laminate treatment of the solar battery module M is performed.

While the laminate treatment of the solar battery module M is thus performed in the laminate unit 3, the next solar battery module M to be subjected to laminate treatment is preferably supplied onto the supply conveyor 6 and is made to stand by on the right of the laminate unit 3.

After the laminate treatment of the solar battery module M is finished, in the laminate unit 3, atmospheric pressure is introduced into the lower chamber 15 through the inlet/outlet port 37. The heating temperature of the heaters 41 is adjusted, and the heater panel 35 is cooled to a predetermined temperature in preparation for the next laminate treatment. By lifting up the upper case 10, the laminating part 2 is brought into an open state. The operation of lifting up the upper case 10 is performed by the extending operation of the cylinders 22 described with FIG. 1. Thereby, the conveying sheet 5 is in the state of being able to advance and retreat between the upper case 10 and the lower case 12 of the laminate unit 3 again.

When the laminating part 2 of the laminate unit 3 is brought into the open state, the rotary rolls 72 and 73 are rotationally driven in the conveying sheet moving mechanism 70, and the conveying sheet 5 is moved leftward, whereby the solar battery module M is moved to the left of the laminate unit 3, and is transferred to the unloading conveyor 7 from the conveying sheet 5. In this way, the moment when the solar battery module M is moved leftward, the supply conveyor 6 is operated, and the solar battery module M kept on standby on the supply conveyor 6 is moved leftward, and is transferred to the conveying sheet 5 from the supply conveyor 6. The next solar battery module M is moved to the position between the upper case 10 and the lower case 12 of the laminate unit 3.

Thereafter, in the laminate unit 3, the same laminate treatment as the aforementioned laminate treatment of the solar battery module M is performed. Specifically, evacuation of the inside of the upper chamber 13 and the inside of the lower chamber 15, heating by the heating panel 35, and expansion of the diaphragm 30 are performed, and the next solar battery module M is sandwiched and pressed between the top surface of the heater panel 35 and the diaphragm 30. Thus, by the heating and sandwiching and pressing, the laminate treatment of the next solar battery module M is performed.

The solar battery module M transferred to the unloading conveyor 7 is removed from the unloading conveyor 7 in sequence by means such as the robot not shown, and is conveyed to the next process. By repeating the above process, the solar battery modules M can be successively subjected to the laminate treatment.

According to this embodiment, spaces (inner parts of the holes 40) between the heater panel 35 and the heaters 41 are hermetically sealed and the predetermined gas such as, for example, air is enclosed in the spaces. Therefore, the density of the gas between the heater panel 35 and the heaters 41 does not change even when the internal pressure of the lower chamber 15 is changed due to the evacuation of the inside of the lower chamber 15 and the introduction of the atmospheric pressure to the lower chamber 15 via the inlet/outlet port 37 during the laminate treatment of the solar battery module M, which can prevent a change in thermal conductivity between the both (the heater panel 35, the heaters 41). Consequently, the temperature of the heater panel 35 is stabilized, and the influence that the change in the internal pressure of the lower chamber 15 has on the temperature of the heater panel 35 is reduced, which can facilitate temperature control of the heater panel 35. Further, since the work and time for correcting the temperature of the heater panel 35 are not necessary, production efficiency in producing the solar battery module M can be more improved than in conventional apparatuses. The above structure remarkably improves production efficiency especially in a case where the internal pressure of the lower chamber 15 is frequently changed due to repeated evacuation of the lower chamber 15, introduction of the atmospheric pressure thereto, and the like during the manufacture of the solar battery module.

Further, an effect of uniform heating of the heater panel 35 in the longitudinal direction X can be obtained in a case where the number of the heaters 41 inserted into each of the holes 40 of the heater panel 35 is set to two for all the holes 40 and the two heaters 41 are disposed in the both end portions in the longitudinal direction X of each of the holes 40 respectively, as shown in FIG 5. For example, in a case where only one heater 41 is disposed in each of the holes 40, the both end portions in the longitudinal direction X of the heater panel 35 may possibly be heated less sufficiently than the center portion. On the other hand, in the case where the two heaters 41 are inserted in each of the holes 40 as described above, the length in the longitudinal direction X of each of the heaters 41 is short and thus variation in temperature of the heating portion 45 reduces, and therefore, the both end portions in the longitudinal direction X of the heater panel 35 can be surely heated, which enables more uniform heating.

Further, as for each of the nine holes 40, the total length in the longitudinal direction X of the heaters 41 inserted in each of the holes 40 is set shorter than the length in the longitudinal direction X of the hole 40 so that the tip portions Q of the heaters 41 are apart from each other by a predetermined distance. Accordingly, the heaters 41 are prevented from colliding with each other when heated to expand in the longitudinal direction X. This can surely maintain the hermetically sealed structure of the heaters 41, resulting in improved durability and reliability of the laminating apparatus 1 and longer life thereof.

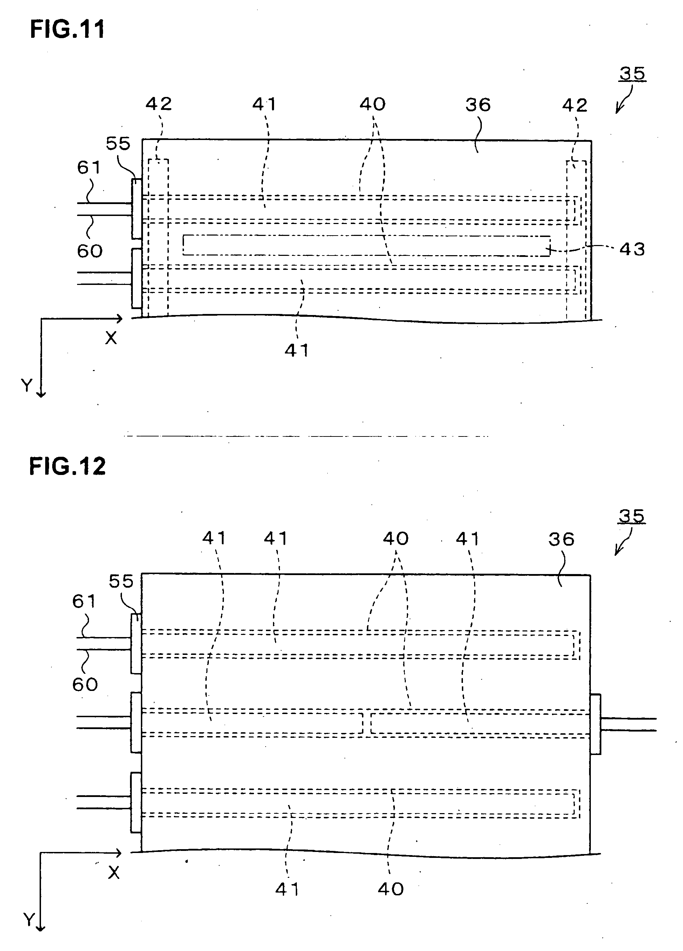

As a second embodiment of the present invention, the number of the heaters 41 inserted in each of the heaters 40 of the heater panel 35 may be one for all the holes 40, as shown in FIG. 11. This reduces the total number of the heaters 41 included in the laminating apparatus 1, and thus their maintenance can be facilitated. It is also possible to further simplify the structure of the laminating apparatus 1. In the laminating apparatus 1 shown in FIG 11, the holes 40 of the heater panel 35 penetrate through one end (left in FIG. 11) in the longitudinal direction X of the heater panel 3 5 to extend up to a position close to the other end (right in FIG. 11). That is, the hole 40 has the one end in the longitudinal direction X open and the other end closed. Each of the heaters 41 is inserted from the open end of the hole 40 and set closer to this one end side. The length in the longitudinal direction X of the heater 41 is set shorter than the length in the longitudinal direction X of the hole 40, so that the tip portion Q of the heater 41 inserted in the hole 40 is a predetermined distance apart from the other closed end of the hole 40. Therefore, the heater 41 is prevented from colliding with the other end of the hole 40 when heated to expand in the longitudinal direction X, and the hermetically sealed structure of the heater 41 can be surely maintained.

Further, in the second embodiment of the present invention, on the undersurface of the heater panel 35, a long auxiliary heater 42 is disposed at a position corresponding to one end side in the longitudinal direction X of the plural holes 40, and another auxiliary heater 42 is disposed at a position corresponding to the other end side. These auxiliary heaters 42 are disposed along the direction Y perpendicular to the longitudinal direction X of the holes 40 (that is, the width direction of the heater panel 35), each being individually controllable. Accordingly, by auxiliary heating of the both end portions in the longitudinal direction X of the heater panel 35 by the use of these auxiliary heaters 42, it is possible to surely heat the both end portions likely to be less sufficiently heated than the center portion in the longitudinal direction X of the heater panel 35, which enables more uniform heating of the whole heater panel 35.

Further, in the second embodiment of the present invention, as shown by the two-dot chain line in FIG. 11, a long heat pipe 43 extending along the longitudinal direction X of the hole 40 is disposed on the undersurface of the heater panel 35. A fluid for heat transport is filled inside the hollow heat pipe 43, and when the temperature of the heater panel 35 becomes uneven in the longitudinal direction X, heat is transported in a direction so as to solve the uneven temperature. This enables more uniform heating in the longitudinal direction X of the heater panel 36. Though only one heat pipe 43 is shown in FIG. 11, but any number of the heat pipes 43 may be used. Further, the heat pipe 43 may be disposed along the direction Y perpendicular to the longitudinal direction X of the hole 40 (that is, the width direction of the heater panel 35).

In the case of the second embodiment, the effects obtained in the first embodiment described by using FIG. 5 are similarly obtained.

As a third embodiment of the present invention, the number of the heaters 41 inserted in each of the holes 40 of the heater panel 35 may be arbitrarily set for each of the holes 40, as shown in FIG. 12. In the heater panel 35 shown in FIG 12, the number of the heaters 41 inserted in the hole 40 is set to one and two alternately along the width direction Y of the heater panel 35. This makes it possible to make the temperature distribution uniform in the longitudinal direction X of the heater panel 35 heated by the heaters 41, without increasing the total number of the heaters 41 included in the heater panel 35. The third embodiment can also provide the same effects as those of the first embodiment described by using FIG. 5.

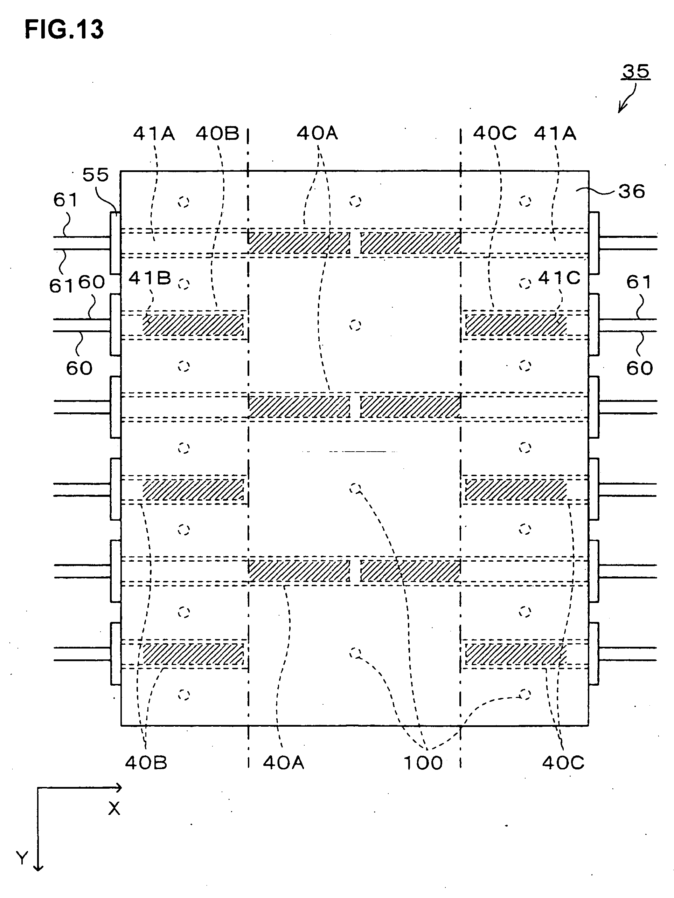

As a fourth embodiment of the present invention, the plural holes 40 provided in the heater panel 35 may include holes 40B (40C) not penetrating through the heater panel 35, as shown in FIG. 13. In the fourth embodiment of the present invention, the holes 40 formed in the heater panel 35 include three holes 40A which penetrate through the heater panel 35, three holes 40B which extend from one end in the longitudinal direction X of the heater panel 35 to a position (position shown by the dashed line in FIG. 13) short of the center portion, and three holes 40C which extend from the other end in the longitudinal direction X of the heater panel 35 to a position (position shown by the dashed line in FIG 13) short of the center portion so as to face the holes 40B respectively. The holes 40A, 40B, and 40C are all formed along the longitudinal direction X of the heater panel 35. Further, sets each consisting of the hole 40B and the hole 40C facing each other, and the holes 40A are alternately arranged along the width direction of the heater panel 35.

Two heaters 41A are disposed in each of the holes 40A. On the other hand, the number of heaters 41B, 41C disposed in each of the holes 40B, 40C is set to one. In the fourth embodiment of the present invention, for example, by the positional adjustment of a lead wire L wound around a core 51 in each of the heaters 41 A, the heaters 41 A generate heat at portions from the center side of the heater panel 35 in the longitudinal direction X to positions substantially coinciding with center side end portions of the holes 40B, 40C (positions shown by the dashed line in FIG. 13), as shown by the hatched portions in FIG. 13. On the other hand, the heaters 41B, 41C generate heat at portions from both end portions in the longitudinal direction X of the heater panel 35 to the center side end portions of the holes 40B, 40C (positions shown by the dashed line in FIG 13), as shown by the hatched portions in FIG. 13.

Outputs of the heaters 41A, 41B, and 41C are individually adjustable based on measurement results obtained by temperature sensors 100 such as, for example, thermoelectric couples provided at different positions of the heater panel 36 and capable of measuring the temperatures of the heaters 41A, 41B, and 41C. As shown in FIG. 13, in the fourth embodiment of the present invention, for example, 18 temperature sensors 100 are provided so as to be dispersed on the entire surface (XY surface) of the heater panel 36. If the results of the temperatures of the heater panel 36 measured by the 18 temperature sensors 100 differ, the heaters 41A, 41B, and 41C are individually controlled so as to eliminate the temperature distribution variation of the heater panel 36, in such a manner that, for example, the output of the heater close to the temperature sensor 100 whose measurement result shows a lower temperature is increased and the output of the heater close to the temperature sensor 100 whose measurement result shows a higher temperature is decreased. This can surely prevent the heater panel 36 from having uneven temperature distribution during the laminate treatment using the heater panel 35. Further, it is possible to appropriately heat the solar battery modules M with various shapes and sizes. The fourth embodiment can also provide the same effects as those of the first embodiment described by using FIG. 5.

The preferred embodiments of the present invention are described above with reference to the attached drawings, but the present invention is not limited to these examples. Those skilled in the art can obviously conceive various modified examples or revised examples within the scope of the technical idea, and it is understood that they belong to the technical range of the present invention as a matter of course.

In the above described embodiments, the case of changing the inner pressure (specifically, evacuation or atmosphere introduction) of both the upper chamber 13 as the first space and the lower chamber 15 as the second space on the occasion of laminating the solar battery module M is described, but the inner pressure of only the lower chamber 15 may be changed.

The above embodiments have described the case where the number of the heaters 41 inserted in each of the holes 40 of the heater panel 35 is two for all the holes 40 (first embodiment), the case where the number is one for all the holes 40 (second embodiment), and the case where the number is one and two alternately along the width direction Y of the heater panel 35 (third embodiment), but the pattern of the number of the heaters 41 inserted in each of the holes 40 of the heater panel 35 may be different from the above patterns. The heaters 41 according to the embodiments of the present invention may be combined with conventionally known heaters.

The above embodiments have described the cases where the number of the holes 40 arranged in parallel in the heater panel 35 is nine, but the number of the holes 40 may be any.

The above embodiments have described the cases where the plural holes 40 are arranged in parallel so that the longitudinal direction thereof is parallel to the longitudinal direction X of the heater panel 35, but the plural holes 40 may be arranged in other form.

The above embodiments have described the cases where the screws each having the shaft portion including the thread and the head portion are used as the fixtures 62 to fix the metal disks 55 of the heaters 41 to the metal plate 36 of the heater panel 35, but other methods may used for fixing, such as, for example, a method of screw-connecting each of the heaters 41 to the metal plate 36 of the heater panel 35 by setting the diameter of the flange portion 46 of the heater 41 substantially equal to the inside diameter of the long hole 40, and providing threads engaged with each other on an outer surface of the flange portion 46 and an inner surface of the long hole 40.

The above embodiment has described the case where one long auxiliary heater 42 and another one long auxiliary heater 42 are respectively provided on the both ends in the longitudinal direction X of the heater panel 35, on the undersurface of the heater panel 35 in which the number of the heaters 41 inserted in each of the long holes 41 having the one end open and the other end closed is set to one for all the holes 41, but the long holes 41 of the heater panel 35 provided with the auxiliary heaters 42 may penetrate through the heater panel 35, and the number of the heaters 41 inserted in each of the holes 40 may be any. Further, the shape of the auxiliary heaters 42 may be any shape other than the long shape. Further, the number of the installed auxiliary heaters 42 may be any, and the auxiliary heater 42 may be installed only on one end in the longitudinal direction X of the heater panel 35.

In the above described embodiments, production of the solar battery module is described as one example of the object to be laminated, but the laminating apparatus of the present invention can also apply laminate treatment to various things in addition to this, and is especially preferable for production of a laminated object in a thin plate shape. The laminating apparatus of the present invention also can be used for production or the like of an integrated module in which an external wall material or a roofing material for a building material and a solar battery module are integrated. Further, the laminating apparatus of the present invention can be used for production of laminated glass, ornamental glass and the like without being limited to the solar battery module.

In the above described embodiments, the case where the laminate treatment is performed by using the fixed heater panel 35 is described, but the laminate treatment may be performed by using the heater panel 35 which can be raised and lowered.

In the above described embodiments, the laminating part 2 including the diaphragm 30 above the solar battery module M and the heater panel 35 below the solar battery module M is described, but the constitution of the laminating part 2 is not limited to such a constitution. For example, it may be a constitution or the like which includes the heater panel above the solar battery module M and sandwiches and presses the solar battery module M by the heater panel and the conveying sheet.

In the above described embodiments, the size of about 2150 mmx4000 mm is shown as an example as the size capable of being laminated in the laminating part 2, and the size of about 2150 mm x 4000 mm is shown as an example as the size of the solar battery module M, but they are not limited to these sizes as a matter of course.

In the above described embodiments, the case where the heaters 41 provided in the heater panel 35 are cartridge heaters is described, but other heaters may be used.

The present invention is especially useful for the laminating apparatus which laminates objects to be laminated such as a light transmissive substrate, a filler, and a solar battery element, for example, and produces a solar battery module.

According to the present invention, easier temperature control of the heater panel is realized owing to the reduction in the influence given to the temperature of the heater panel by the internal pressure change in the chamber where the heater panel is installed. Accordingly, during the laminate treatment of the solar battery module, the heating temperature for laminating the solar battery module can be stabilized and the extra work and time are eliminated, which can improve production efficiency.

## Claims

1. A laminating apparatus heating an object (M) to be laminated and pressing the object (M) to be laminated in a sandwiched state, comprising:
a first space (13) whose internal pressure is adjustable;
a second space (15) which is separated from said first space (13) by an expandable diaphragm (30) and whose internal pressure is adjustable;
a heater panel (35) provided inside said second space (15);
one hole (40) or more provided inside said heater panel (35); and
one heater (41) or more inserted in said hole (40);
**characterized in that**
the apparatus further comprises a heat transfer material filled inside said hole (40), wherein said hole (40) is hermetically sealed.

2. The laminating apparatus according to claim 1, wherein the heat transfer material inside said hole is air.

3. The laminating apparatus according to claim 1, wherein a total length of said one heater (41) or more is set shorter than a length of said hole (40).

4. The laminating apparatus according to claim 1, wherein the object (M) to be laminated is a solar battery module.

5. The laminating apparatus according to claim 1, wherein said hole (40) includes a hole penetrating through said heater panel (35).

6. The laminating apparatus according to claim 4, wherein said heaters (41) are inserted from both ends of said hole (40) penetrating through said heater panel (35), with a space formed between tips of said inserted heaters (41).

7. The laminating apparatus according to claim 1, wherein said hole (40) includes a long hole having one end portion in a longitudinal direction open and the other end portion closed.

8. The laminating apparatus according to claim 1 , further comprising auxiliary heaters (42) provided on an undersurface of said heater panel (35), at positions of longitudinal end portions of said hole (40).

## Patentansprüche

1. Laminiervorrichtung, die ein zu laminierendes Objekt (M) erwärmt und das zu laminierende Objekt (M) in einem übereinander geschichteten Zustand unter Druck setzt, umfassend:
einen ersten Raum (13), dessen Innendruck einstellbar ist;
einen zweiten Raum (15), der vom ersten Raum (13) durch eine nachgiebige Membran (30) getrennt ist, und dessen Innendruck einstellbar ist;
eine Heizplatte (35), die innerhalb des zweiten Raums (15) vorgesehen ist;
ein Loch (40) oder mehrere Löcher, die innerhalb der Heizplatte (35) vorgesehen sind; und
ein Heizelement (41) oder mehrere Heizelemente, die in das Loch (40) eingeführt sind;
**dadurch gekennzeichnet, dass**
die Vorrichtung ferner ein Wärmeübertragungsmaterial umfasst, das in das Loch (40) gefüllt ist, wobei das Loch (40) hermetisch abgedichtet ist.

2. Laminiervorrichtung nach Anspruch 1, bei der das Wärmeübertragungsmaterial innerhalb des Loches Luft ist.

3. Laminiervorrichtung nach Anspruch 1, bei der eine Gesamtlänge dieses einen Heizelements (41) oder dieser mehreren Heizelemente kürzer als eine Länge des Loches (40) ist.

4. Laminiervorrichtung nach Anspruch 1, bei der das zu laminierende Objekt (M) ein Solarbatteriemodul ist.

5. Laminiervorrichtung nach Anspruch 1, bei der das Loch (40) ein durch die Heizplatte (35) hindurch führendes Loch umfasst.

6. Laminiervorrichtung nach Anspruch 4, bei der die Heizelemente (41) von beiden Enden des Loches (40) eingeführt sind, das durch die Heizplatte (35) hindurch führt, mit einem Zwischenraum zwischen den Enden der eingeführten Heizelemente (41).

7. Laminiervorrichtung nach Anspruch 1, bei der das Loch (40) ein Langloch umfasst, dessen einer Endabschnitt in einer Längsrichtung offen und dessen anderer Endabschnitt geschlossen ist.

8. Laminiervorrichtung nach Anspruch 1, die ferner Hilfsheizelemente (42) umfasst, die unter einer Oberfläche der Heizplatte (35) vorgesehen sind, an Positionen der Längsendabschnitte des Loches (40).

## Revendications

1. Appareil de laminage chauffant un objet (M) à laminer et pressant l'objet (M) à laminer dans un état pris en sandwich, comprenant :
un premier espace (13) dont la pression interne est ajustable ;
un deuxième espace (15) qui est séparé dudit premier espace (13) par un diaphragme expansible (30) et dont la pression interne est ajustable ;
un panneau de réchauffeur (35) fourni à l'intérieur dudit deuxième espace (15) ;
un trou (40) ou plus fourni à l'intérieur dudit panneau de réchauffeur (35) ; et
un réchauffeur (41) ou plus inséré dans ledit trou (40) ;
**caractérisé en ce que**
l'appareil comprend en outre un matériau de transfert de chaleur rempli à l'intérieur dudit trou (40), dans lequel ledit trou (40) est scellé hermétiquement.

2. Appareil de laminage selon la revendication 1, dans lequel le matériau de transfert de chaleur à l'intérieur dudit trou est l'air.

3. Appareil de laminage selon la revendication 1, dans lequel une longueur totale dudit un réchauffeur (41) ou plus est réglée plus courte qu'une longueur dudit trou (40).

4. Appareil de laminage selon la revendication 1, dans lequel l'objet (M) à laminer est un module de batterie solaire.

5. Appareil de laminage selon la revendication 1, dans lequel ledit trou (40) comprend un trou pénétrant à travers ledit panneau de réchauffeur (35).

6. Appareil de laminage selon la revendication 4, dans lequel lesdits réchauffeurs (41) sont insérés des deux extrémités dudit trou (40) pénétrant à travers ledit panneau de réchauffeur (35), avec un espace formé entre des bouts desdits réchauffeurs insérés (41).

7. Appareil de laminage selon la revendication 1, dans lequel ledit trou (40) comprend un long trou ayant une partie d'extrémité dans une direction longitudinale ouverte et l'autre partie d'extrémité fermée.

8. Appareil de laminage selon la revendication 1, comprenant en outre des réchauffeurs auxiliaires (42) fournis sur une surface de dessous dudit panneau de réchauffeur (35) à des positions de parties d'extrémités longitudinales dudit trou (40).
